# EUROPÄISCHE PATENTSCHRIFT

(11) **EP 2 886 463 B1**
(45) Veröffentlichungstag und Bekanntmachung des Hinweises auf die Patenterteilung: **07.02.2024**
(21) Anmeldenummer: 14004165.8
(22) Anmeldetag: 11.12.2014
(51) Int. Cl.: B64D 15/16

(54) **AKTUATORMONTAGEVERFAHREN UND HERSTELLVERFAHREN FÜR EINE EISSCHUTZVORRICHTUNG**
ACTUATOR INSTALLATION METHOD AND MANUFACTURING METHOD FOR ICE PROTECTION DEVICE
PROCÉDÉ DE MONTAGE D'ACTIONNEUR ET PROCÉDÉ DE FABRICATION POUR UN DISPOSITIF ANTI-GIVRAGE

(30) Priorität: 11.12.2013 DE 102013020496
(43) Veröffentlichungstag der Anmeldung: 24.06.2015
(73) Patentinhaber: Airbus Defence and Space GmbH, 85521 Ottobrunn (DE)
(72) Erfinder: Strobl, Tobias, 80333 München (DE); Storm, Stefan, 85716 Unterschleißheim (DE)
(74) Vertreter: Kastel, Stefan

(56) Entgegenhaltungen:
- EP-A2- 0 739 656
- EP-A2- 0 855 340
- WO-A1-2007/071231
- WO-A2-2004/047192
- DE-A1-102004 060 675
- DE-A1-102011 078 706
- US-A- 3 519 229
- US-A- 6 097 135
- US-A1- 2013 032 671
- KAMEL AL-KHALIL ET AL: "A hybrid anti-icing ice protection system", AMERICAN INSTITUTE OF AERONAUTICS AND ASTRONAUTICS. AIAA MEETING PAPERS, 1. Januar 1997 (1997-01-01), XP055190089, Reston

## Beschreibung

Die Erfindung betrifft ein Aktuatormontageverfahren zum Montieren wenigstens eines Aktuators. Insbesondere betrifft die Erfindung ein Aktuatormontageverfahren zur Herstellung einer mechanischen Eisschutzeinrichtung für ein Luftfahrzeug zum Vermeiden einer Eisbildung an einem Oberflächenbereich und/oder Enteisen des Oberflächenbereichs des Luftfahrzeuges. Außerdem betrifft die Erfindung eine Montagevorrichtung zur Verwendung in einem solchen Verfahren und ein Herstellverfahren zur Herstellung einer hybriden Vorrichtung zur Enteisung und/oder zur Vemeidung von Eisbildung für ein Luftfahrzeug.

Die Erfindung liegt auf dem technischen Gebiet der Montage von Aktuatoren. Die Erfindung wird beispielhaft anhand der Herstellung und/oder Montage einer Vorrichtung zur Enteisung und/oder Vermeidung von Eisbildung für ein Luftfahrzeug erläutert, ist aber nicht auf dieses Gebiet beschränkt.

Eis bildet sich an exponierten Stellen von Luftfahrzeugen wie Vorderkanten von Flügeln, Leitwerken, horizontalen Stabilisatoren oder auch Triebwerkseinläufen, wenn das Luftfahrzeug, wie beispielsweise ein Flugzeug, durch eine Wolke fliegt, die unterkühlte Wassertröpfchen enthält oder Tropfen/Feuchtigkeit auf eine unterkühlte Luftfahrzeugstruktur treffen. Wenn eine Eisschicht wächst, beeinträchtigt sie die Luftströmung über der betroffenen Oberfläche. Wenn die Schicht groß genug wird, können z.B. Tragprobleme oder Handhabungsprobleme für das Luftfahrzeug entstehen.

Es sind bereits Eisschutzsysteme bei Luftfahrzeugen im Einsatz, um eine solche Eisbildung zu vermeiden. Die meisten Eisschutzsysteme sind als Anti-Eissysteme zum Vermeiden einer Eisbildung ausgebildet. Hierzu sind in der Regel Struktur-integrierte Heizsysteme vorgesehen. Während des Fluges unter Vereisungsbedingungen werden Flügelkanten z. B. mit heißer Abzweigluft oder Verdichterzapfluft (sog. bleed air) oder durch elektrische Heizungen in den Flügelkanten beheizt. Zudem sind, vor allem in kleineren Flugzeugen, pneumatisch betriebene Enteisungsvorrichtungen im Einsatz, welche an der Flügelvorderkante integrierte Gummimatten bzw. Gummischläuche in regelmäßigen Abständen aufblasen, wodurch ein Ablösen von angelagertem Eis erzielt wird.

Dabei sind die herkömmlichen Enteisungsmaßnahmen mit einem hohen energetischen Aufwand während des Fluges verbunden. An energetischem Aufwand für das Freimachen von Oberflächen des Luftfahrzeuges von Eis fallen etwa 240 bis 260 kW an Abzweigluftleistung oder ca. 130 bis 150 kW elektrischer Heizleistung für eine zu enteisende Fläche von ca. 12 bis 15 m² an. Diese Daten entsprechen im Falle von Abzweigluft Flächenleistungen von ca. 18,5 kW/m² bzw. etwa 10 kW/m² bei elektrischer Heizung.

Bekannte Systeme oder Vorrichtungen zur Entfernung von Eisakkumulationen im Flug auf aerodynamisch effizienten Oberflächen lassen sich generell unterteilen in pneumatische, thermische und mechanische Enteisungssysteme. So ist in der EP 0 658 478 B1 eine Vorrichtung zur pneumatischen Enteisung von Oberflächen an Luftfahrzeugen bekannt. Aus der US 6 702 233 B1 ist eine Vorrichtung zur Enteisung beziehungsweise Vermeidung von Eisbildung an Oberflächenbereichen von Luftfahrzeugen unter Verwendung von warmer Abzweigluft aus dem Triebwerk bekannt. Aus der US2013/032671 A1 ist eine Vorrichtung zur Vermeidung von Eisbildung unter Verwendung von piezoelektrischen Aktuatoren bekannt.

Aus der DE 10 2010 045 450 B4 ist eine Anordnung zur Enteisung eines Oberflächenbereichs eines Luftfahrzeuges durch Bestrahlung des Oberflächenbereichs mit einem Laser bekannt.

Andere Vorrichtungen zur Enteisung und/oder Vermeidung von Eisbildung verwenden eine thermische Enteisung unter Verwendung von elektrischen Heizelementen. Insbesondere ist es bekannt, basierend auf der großflächigen Wärmezufuhr durch eine elektrothermische Heizmatte das Vereisen der Oberfläche eines Flügelprofils zu verhindern. Ein Beispiel für ein derartiges thermisches Enteisungssystem ist in der EP 1 017 580 B1 beschrieben.

Weiter sind auch Vorrichtungen zur Enteisung und/oder Vermeidung von Eisbildung bekannt, die als hybride Vorrichtungen mehrere Möglichkeiten zur Enteisung, wie insbesondere den Einsatz thermischer Energie und mechanischer Verformungen nutzen. Beispiele von bekannten hybriden Enteisungssystemen sind aus den folgenden Literaturstellen bekannt:
- G. Fortin, M. Adomou, J. Perron, "Experimental Study of Hybrid Anti-Icing Systems Combining Thermoelectric and Hydrophobic Coatings", SAE International, Warrendale, Pa, 2011: Diese Publikation beschäftigt sich mit einem elektro-thermischen Anti-Eis-System in Kombination mit Eis abweisenden Oberflächenbeschichtungen zur Reduktion des Energiebedarfs bei der Enteisung. Die Wärmezufuhr erfolgt bei diesem System großflächig, um die gesamte, von Eisaufwuchs betroffene Oberfläche zu schützen. Der Nachteil des Systems ist somit die Tatsache, dass durch den permanenten Betrieb des großflächig anzubringenden Anti-Eis-Systems im Bereich der gesamten Flügelvorderkante ein grundsätzlich hoher Energieverbrauch auftritt.
- K. Al-Khalil, T. Ferguson, D. Phillips, "A Hybrid Anti-icing Ice Protection System", AIAA 97-0302 (1997): Diese Publikation befasst sich mit einem hybriden Enteisungssystem der Firma Cox & Company, Inc. welches sich aus einem thermischen "Running-wet"-Anti-Eis-Subsystem sowie einem Subsystem auf Basis von elektro-expulsiven Aktuatoren (EMEDS) zusammensetzt. Das thermische Subsystem bedeckt den Bereich des Tropfenaufschlags an der Flügelvorderkante in großflächiger Weise entweder teilweise oder auch vollständig. Somit lässt sich für das thermische Subsystem der Nachteil anführen, dass ein relativ großer Flächenanteil des Flügelvorderkantenbereichs beheizt werden muss, um die Wassertropfen weiter stromabwärts zu transportieren. Dort können die zu einer Eisakkumulation erstarrten Tropfen dann mittels der EMEDS-Aktuatoren periodisch entfernt werden. Ein weiterer Nachteil des bekannten hybriden Systems ist zudem die Größe der EMEDS-Aktuatoren.

Aus der WO 2007/071231 A1 sind beispielsweise dreidimensionale Piezoakutatoren bekannt, die komplexe Verformungszustände an unterschiedlichen Basisstrukturen erzeugen können. Basisstrukturen können etwa große Hohlspiegel von Teleskopen oder aerodynamische Profile sein. Insbesondere können die Piezoaktuatoren zur Untersuchung von Strömungseigenschaften der aerodynamischen Profile verwendet werden.

Der Erfindung liegt die Aufgabe zugrunde, die Montage von Aktuatoren zu verbessern.

Diese Aufgabe wird durch ein Aktuatormontageverfahren nach Anspruch 1 gelöst. Eine vorteilhafte Verwendung des Aktuatormontageverfahrens bei der Herstellung einer mechanischen Vorrichtung zur Enteisung und/oder Vermeidung von Eisbildung und bei der Herstellung einer hybriden Vorrichtung zur Enteisung und/oder Vermeidung von Eisbildung sind Gegenstand der Nebenansprüche.

Vorteilhafte Ausgestaltungen der Erfindung sind Gegenstand der Unteransprüche.

Die Erfindung schafft ein Aktuatormontageverfahren zum Montieren wenigstens eines Aktuators in einer stark gekrümmten oder einen engen Raum einschließenden Schalenstruktur eines Profils eines Profilkörpers eines Luftfahrzeuges, umfassend die Schritte:
a) Bereitstellen einer Schalenstruktur,
b) Bereitstellen wenigstens eines Aktuators, der zur Verformung des Oberflächenbereichs der Schalenstruktur geeignet ist durch Bereitstellen wenigstens eines ersten Aktuators zur Verformung eines auf einer ersten Längshälfte der Schalenstruktur ausgebildeten Abschnitts des Oberflächenbereichs und Bereitstellen wenigstens eines zweiten Aktuators zur Verformung eines auf einer zweiten Längshälfte der Schalenstruktur ausgebildeten Abschnitts des Oberflächenbereichs, und
c) Befestigen des wenigstens einen Aktuators an einer Innenseite der Schalenstruktur durch gleichzeitiges Befestigen des wenigstens einen ersten Aktuators an der Innenseite der ersten Längshälfte und des wenigstens einen zweiten Aktuators an der Innenseite der zweiten Längshälfte,
wobei Schritt c) enthält:
c1) Anordnen des wenigstens einen Aktuators an einem Stempel zum flächigen Anpressen des wenigstens einen Aktuators an der Innenseite der Schalenstrukur,
c2) Anhaften des Aktuators an den Stempel mittels eines lösbaren Haltemittels,
c3) Anpressen des Aktuators an die Innenseite der Schalenstruktur innerhalb des Profils mittels des Stempels,
c4) Verbinden des Aktuators mit der Innenseite,
c5) Lösen und/oder Entfernen des Stempels.

Es ist bevorzugt, dass Schritt c4) enthält:
c4.1) stoffschlüssiges Verbinden des Aktuators mit der Innenseite.

Es ist bevorzugt, dass Schritt c4) enthält:
c4.2)Verkleben des Aktuators mit der Innenseite.

Es ist bevorzugt, dass Schritt c4) enthält:
c4.2.1) Auftragen eines Klebemittels auf die Innenseite und/oder eine mit der Innenseite zu verklebende Fläche des Aktuators vor dem Anbringen des Aktuators an die Innenseite.

Es ist bevorzugt, dass Schritt c4) enthält:
c4.2.2) Aushärten des Klebemittels unter Anpressen des Aktuators an die Innenseite.

Es ist bevorzugt, dass Schritt c4.2.2) enthält:
Das Aushärten des Klebemittels unter Temperaturbeaufschlagung zum Erzeugen einer mechanischen Vorspannung aufgrund der unterschiedlichen Wärmeausdehnungskoeffizienten des Aktuatormaterials und der Schalenstruktur.

Es ist bevorzugt, dass Schritt c4) enthält:
c4.3)Zwischenlage einer elektrischen Isolationsschicht zwischen Aktuator und Innenseite.

Es ist bevorzugt, dass Schritt c2) enthält:
c2.1) Halten des Aktuators an dem Stempel beispielsweise mittels zweiseitigen Klebebands während des Einbringens in die Schalenstrukur und/oder des Anbringens an die Schalenstruktur. Alternativ oder zusätzlich kann eine temporäre, lösbare Verbindung des Aktuators mit dem Stempel, etwa durch elektrostatische Anziehung oder durch Ansaugen des Aktuators an den Stempel hergestellt werden.

Es ist bevorzugt, dass Schritt c3) enthält:
c3.1) geführtes Bewegen des Stempels durch eine Führungseinrichtung.

Es ist bevorzugt, dass Schritt c3) enthält:
c3.2)Aufrechterhalten und/oder Konstanthalten eines Pressdrucks mittels eines Kraftspeichers, wie z.B. wenigstens einer Tellerfeder.

Es ist bevorzugt, dass Schritt c3) enthält:
c3.3)Abstützen der Außenseite der Schalenstruktur mittels einer zu der Außenseite komplementären Stützform.

Es ist bevorzugt, dass Schritt a) enthält:
Bereitstellen der Schalenstrukur mit wenigstens einer ebenen Innenfläche auf der Innenseite der Schalenstrukur. Alternativ oder zusätzlich kann auch ein Aktuator verwendet werden, welcher die gleiche Krümmung wie die Schalenstruktur aufweist.

Es ist bevorzugt, dass Schritt c) enthält:
Befestigen des wenigstens einen Aktuators an der wenigstens einen ebenen Innenfläche.

Es ist bevorzugt, dass Schritt b) enthält:
b.1) Bereitstellen wenigstens eines piezoelektrischen Aktuators.

Gemäß einem weiteren Aspekt schafft die Erfindung ein Herstellverfahren zum Herstellen einer hybriden Enteisungsvorrichtung für ein Luftfahrzeug, zum thermischen und mechanischen Enteisen eines Oberflächenbereichs und/oder zum thermischen und mechanischen Freihalten des Oberflächenbereichs, umfassend:
Durchführen eines Aktuatormontageverfahren gemäß einer der zuvor beschriebenen Ausgestaltungen zwecks Herstellen und/oder Montage der mechanischen Eisschutzeinrichtung und durch den Schritt:
d) Anbringen einer Wärmeabgabeeinrichtung zum Erwärmen zumindest eines Teils der Schalenstruktur.

Es ist bevorzugt, dass Schritt d) enthält:
d1) Bereitstellen einer Wärmeabgabeeinrichtung (12), die zur linienförmigen Wärmeabgabe zwecks Erzeugung einer Sollbruchstelle oder Sollbruchlinie (32) oder Trennlinie in sich auf dem Oberflächenbereich ansammelndem Eis ausgebildet ist.

Es ist bevorzugt, dass Schritt d) enthält:
d2) Anbringen der Wärmeabgabeeinrichtung (12) an der Innenseite der Schalenstruktur im Bereich einer Vorderkante und/oder einer Stagnationslinie eines durch die Schalenstruktur zu bildenden aerodynamischen Profilkörpers.

Es ist bevorzugt, dass der zu montierende wenigstens eine piezoelektrische Aktuator als d₃₃-Stapelaktuator oder Multilayeraktuator ausgebildet ist.

Vorzugsweise erfolgt die Montage des Aktuators derart, dass die Ausdehungsrichtung des wenigstens einen Aktuators, insbesondere des wenigstens einen piezoelektrischen Aktuators bei Verwendung an einem Profil eines Flügels in Spannweitenrichtung ausgerichtet ist. Insbesondere ist die Ausdehnungsrichtung mit zumindest einer Richtungskomponente in parallel zu der zu verformenden Oberfläche ausgerichtet, vorzugsweise mit einer Richtungskomponente quer zur Anströmungsrichtung wie z.B. der Flugrichtung. Bei entsprechend fester Verbindung von Aktuator und Schalenstruktur bewirkt dann eine Änderung der Ausdehnung der Aktuatoren eine entsprechende Verspannung der Schalenstruktur, so dass eine Verformung wie z.B. eine Einbeulung oder Ausbeulung erzielbar ist.

Anwendungsgebiete der Verfahren und Vorrichtungen der Erfindung betreffen bevorzugt die Montage und die Herstellung von Vorrichtungen zur Enteisung und/oder Vermeidung von Eisbildung. Insbesondere betrifft die Erfindung die Montage von Aktuatoren zur Verformung oder Bewegung von Oberflächenbereichen, um so mittels mechanischer Energie Eis zu entfernen oder die Entstehung von Eis zu vermeiden.

Gemäß einem weiteren Aspekt schafft die Erfindung ein Herstellverfahren zur Herstellung einer mechanischen Eisschutzeinrichtung für ein Luftfahrzeug zum Enteisen eines Oberflächenbereichs des Luftfahrzeuges mittels Durchführen eines Aktuatormontageverfahrens zuvor beschriebenen Aktuatormontageverfahrens, wobei die Schalenstruktur den an deren Außenseite der von Eis freizuhaltenden und/oder zu enteisenden Oberflächenbereich aufweist.

Es ist bevorzugt, dass die damit herzustellende Vorrichtung als hybride Vorrichtung zur Enteisung und/oder Vermeidung von Eisbildung mittels thermischer und mechanischer Energie ausgebildet ist.

Vorzugsweise lässt sich eine Vorrichtung zur Enteisung und/oder Vermeidung von Eisbildung für ein Luftfahrzeug schaffen, mit einer Wärmeabgabeeinrichtung zur Abgabe von Wärme an einen Oberflächenbereich des Luftfahrzeuges, wobei die Wärmeabgabeeinrichtung zur linienförmigen Wärmeabgabe zwecks Erzeugung einer Sollbruchstelle oder Sollbruchlinie in sich auf dem Oberflächenbereich ansammelndem Eis ausgebildet ist.

Eine bevorzugte Ausgestaltung der Vorrichtung zur Enteisung und/oder Vermeidung von Eisbildung umfasst eine Verformungseinrichtung zur Verformung zumindest eines Teils der Oberfläche des Oberflächenbereichs.

Es ist bevorzugt, dass die Verformungseinrichtung wenigstens einen piezoelektrischen Aktuator oder eine Anordnung von piezoelektrischen Aktuatoren zur Verformung einer Oberfläche des Oberflächenbereichs aufweist.

Vorzugsweise werden derartige Aktuatoren mit dem Montageverfahren gemäß der Erfindung an einer Schalenstruktur eines aerodynamischen Profilkörpers montiert.

Eine vorzugsweise zusätzlich zu der mechanischen Eisschutzeinrichtung vorzusehende Wärmeabgabeeinrichtung ist zur Wärmeabgabe in Linienform ausgebildet, um so eine Sollbruchstelle oder Sollbruchlinie von sich auf dem Oberflächenbereich ansammelndem Eis zu erzeugen. Die Wärmeabgabeeinrichtung ist somit zur Wärmeabgabe entlang einer Wärmeabgabelinie ausgebildet. Je nach Energieeinsatz bildet sich entlang der Wärmeabgabelinie eine Schwächung von darauf befindlichem Eis aus, so dass das Eis aufgebrochen werden kann, oder es bildet sich entlang der Wärmeabgabelinie erst gar kein Eis aus, so dass sich allenfalls Eis an durch die Wärmeabgabelinie getrennten Abschnitten des Oberflächenbereichs ausbilden kann.

Bei einer besonders bevorzugten Ausgestaltung der mit den Montageverfahren gemäß der Erfindung oder deren vorteilhaften Ausgestaltungen zu montierenden Vorrichtung weist die Verformungseinrichtung eine erste Verformungseinheit auf einem ersten Abschnitt des Oberflächenbereichs und eine zweite Verformungseinheit auf einer durch die Wärmeabgabelinie von dem ersten Abschnitt getrennten zweiten Oberflächenbereich auf.

Bevorzugt umfasst die Verformungseinrichtung eine erste Verformungseinheit auf einer ersten Seite von einer Wärmeabgabelinie der Wärmeabgabeeinrichtung, zur Verformung eines auf der ersten Seite befindlichen ersten Abschnitts des Oberflächenbereichs und eine zweite Verformungseinheit auf der zweiten Seite von der Wärmeabgabelinie zur Verformung eines auf der zweiten Seite befindlichen zweiten Abschnitts des Oberflächenbereichs.

In einer besonders bevorzugten Ausgestaltung umfasst die zu montierende Vorrichtung weiter eine Eisadhäsionskräfte herabsetzende Oberflächenbeschichtung für den Oberflächenbereich.

Es ist bevorzugt, dass die Wärmeabgabeeinrichtung wenigstens einen Heizdraht und/oder wenigstens einen piezoelektrischen Aktuator, der derart ausgebildet und eingerichtet ist, dass er zur linienförmigen Wärmeabgabe fähig ist, aufweist.

Ausführungsbeispiele der Erfindung werden nachfolgend anhand der beigefügten Zeichnungen näher erläutert. Darin zeigt:
- Fig. 1: eine schematische, teilweise weggeschnittene Darstellung eines Luftfahrzeuges am Beispiel eines Flugzeuges, wobei die Vorderkanten von aerodynamischen Profilkörpern des Luftfahrzeuges, wie insbesondere Tragflügel, Flossen des Leitwerks und Triebwerkseinläufe mit einer Vorrichtung zur Enteisung und/oder Vermeidung von Eisbildung versehen sind;
- Fig. 2: eine schematische, teils perspektivische, teils geschnittene Darstellung durch einen aerodynamischen Profilkörper, beispielsweise zum Bilden eines Tragflügels des Luftfahrzeugs von Fig. 1, gezeigt im Schnitt entlang der Linie II-II von Fig. 1, wobei der Profilkörper mit der Vorrichtung zur Enteisung und/oder Vermeidung von Eisbildung versehen ist;
- Fig. 3: in schematischer geschnittener Darstellung einen Schnitt durch die Vorderkante des Profilkörpers von Fig. 2 mit der Vorrichtung zur Enteisung und/oder Vermeidung von Eisbildung ohne Betrieb einer Wärmeabgabeeinrichtung;
- Fig. 4: eine Darstellung wie in Fig. 3 bei Betrieb der Wärmeabgabeeinrichtung;
- Fig. 5: eine schematische Darstellung einer Schalenstruktur zum Bilden des Profilkörpers, an den Aktuatoren zum Bilden einer mechanischen Eisschutzeinrichtung der Vorrichtung zu montieren sind;
- Fig. 6: eine Prinzipdarstellung einer Montagevorrichtung zur Durchführung einer Montage von Aktuatoren an der Schalenstruktur von Fig. 5; und
- Fig. 7 bis 10: in schematischer Darstellung Längsschnitte durch die Montagevorrichtung mit der Schalenstruktur zur Verdeutlichung unterschiedlicher Schritte eines Montageverfahrens.

Im Folgenden werden Ausführungsbeispiele eines Aktuatormontageverfahrens sowie eines unter Verwendung dieses Aktuatormontageverfahrens durchführbaren Herstellverfahrens zur Herstellung einer Vorrichtung 10 zur Enteisung und/oder Vermeidung von Eisbildung näher erläutert.

Das Aktuatormontageverfahren ist nicht auf die Verwendung bei Vorrichtungen zur Enteisung und/oder Vermeidung von Eisbildung beschränkt, sondern kann allgemein zum Montieren eines Aktuators in einem schalenförmigen Körper verwendet werden.

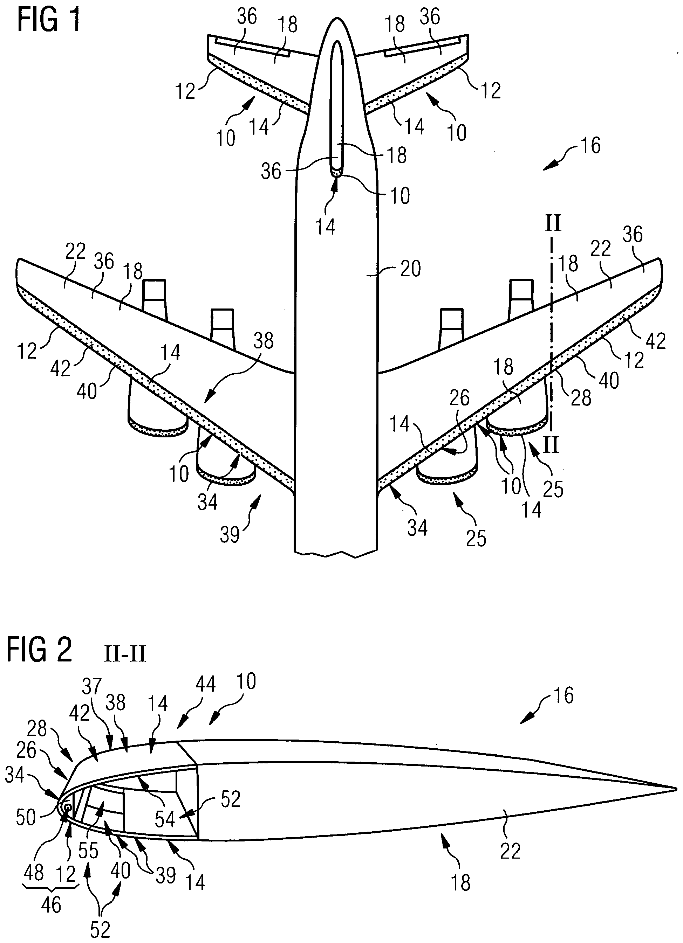

Hierzu werden zunächst anhand der Figuren 1 bis 4 Ausführungsbeispiele einer unter Verwendung dieser Verfahren erhältlichen Vorrichtung 10 zur Enteisung und/oder Vermeidung von Eisbildung an einem Oberflächenbereich 14 eines Luftfahrzeuges 16 sowie deren Funktion näher erläutert, bevor auf die einzelnen Schritte der Montage anhand der verbleibenden Figuren näher eingegangen wird.

Die Darstellungen in den Fig. 1 und 2 stellen lediglich Ausführungsbeispiele dar. Viele andere abweichende Ausgestaltungen der Vorrichtung 10 sind möglich.

Fig. 1 zeigt ein Luftfahrzeug 16 in Form eines Flugzeuges 20. Das Flugzeug 20 weist jeweils durch Profilkörper 18 gebildete Flügel 22, Leitwerksflossen 24 und Triebwerkseinläufe 25 auf. Im Bereich um die Vorderkanten 26 der Profilkörper 18 der Flügel 22 sowie der Leitwerksflossen 24 und Triebwerkseinläufe 25 befindet sich der Oberflächenbereich 14, an dem sich im Flug Eis ansammeln kann.

Um dem entgegenzuwirken, weist das Luftfahrzeug 16 eine Vorrichtung 10 zur Enteisung und/oder Vermeidung von Eisbildung an dem Oberflächenbereich 14 auf. Die Vorrichtung 10 weist eine Wärmeabgabeeinrichtung 12 zur Abgabe von Wärme an den Oberflächenbereich 14 auf.

Die Wärmeabgabeeinrichtung 12 ist vorzugsweise nicht zur großflächigen Wärmeabgabe ausgebildet, sondern zur linienförmigen Wärmeabgabe entlang einer Wärmeabgabelinie 28. Durch eine linienförmige Abgabe entlang der Wärmeabgabelinie 28 lässt sich an dem Oberflächenbereich 14 ansammelndes Eis 30 linienförmig schwächen und entlang der Wärmeabgabelinie 28 trennen. Insofern ist die Wärmeabgabeeinrichtung 12 zum Ausbilden einer Sollbruchstelle beziehungsweise einer Sollbruchlinie 32 für das Eis 30 ausgebildet.

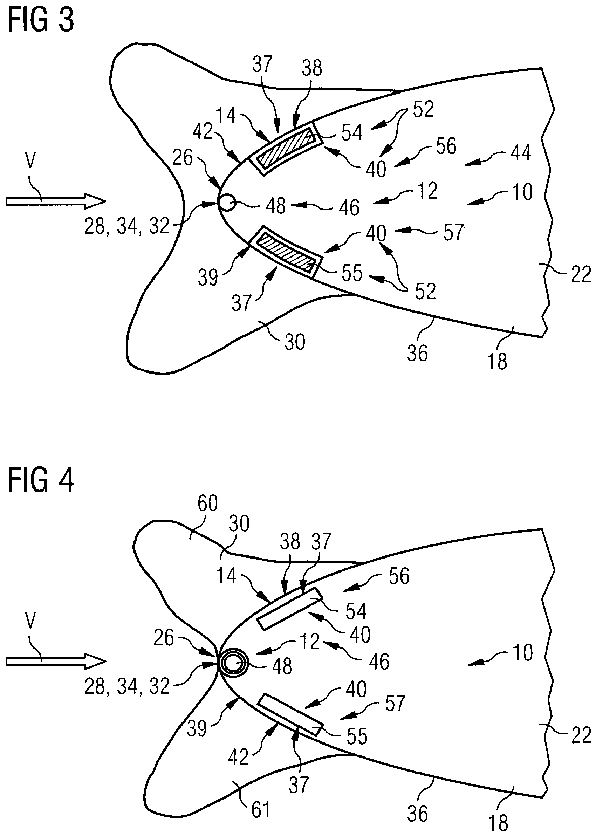

In bevorzugter Ausgestaltung ist die Wärmeabgabeeinrichtung 12 derart ausgebildet, dass die Wärme entlang der äußersten Vorderkante 26 und insbesondere entlang der Stagnationslinie 34 des jeweiligen aerodynamischen Profils 36 des jeweiligen Profilkörpers 18 linienförmig abgegeben wird. Die Stagnationslinie 34 ist die Linie, die die Staupunkte des aerodynamischen Profils 36 miteinander verbindet, oder mit anderen Worten diejenige Linie an einem aerodynamischen Profil 36, an der bei entsprechender Luftanströmung - in Fig. 3 und 4 dargestellt durch den Pfeil und den Geschwindigkeitsvektor v - in Strömungen zu den beiden Seiten beziehungsweise nach oben und nach unten hin aufgeteilt wird. Entlang der Stagnationslinie 34 baut sich im Flug der höchste Druck auf.

Bei einer weiter bevorzugten Ausgestaltung ist die Wärmeabgabeeinrichtung 12 derart ausgebildet, dass die Wärme entlang der momentanen Stagnationslinie 34 des jeweiligen aerodynamischen Profils 36 des jeweiligen Profilkörpers 18 abgegeben wird. Dies kann beispielsweise durch mehrere, linienförmig im Bereich an der Flügelvorderkante angebrachte Heizdrähte realisiert werden. Somit kann auch unter Flugbedingungen mit verschiedener Anstellung der Flügeltragflächen bzw. des Flügelprofils gewährleistet werden, dass das Eis an bzw. nahe an der jeweiligen Stagnationslinie durch den linienförmigen Wärmeeintrag aufgespalten wird.

Die Vorrichtung 10 weist weiter Eisschutzeinrichtungen 37 zur Entfernung von Eis und/oder zur Vermeidung einer Eisansammlung in oder an den durch die Wärmeabgabelinie 28 beziehungsweise Stagnationslinie 34 geteilten Abschnitten 38, 39 des Oberflächenbereich 14 auf.

Bei der dargestellten Ausgestaltung ist als Beispiel für eine Eisschutzeinrichtung 37 eine Verformungseinrichtung 40 zur Verformung von entsprechenden Teilen oder Abschnitten 38, 39 des Oberflächenbereichs 14 vorgesehen.

Weitere Maßnahmen können vorgesehen sein. Z.B. ist bei der dargestellten Ausgestaltung an dem Oberflächenbereich 14 zusätzlich eine Oberflächenbeschichtung 42 zur Verminderung von Eisadhäsionskräften vorgesehen.

Die Vorrichtung 10 ist gemäß einer bevorzugten Ausgestaltung als hybrides Enteisungssystem 44 ausgebildet, das eine Eisentfernung oder Vermeidung von Eisbildung unter Einsatz von wenigstens zwei Prinzipien durchführt.

Die Wärmeabgabeeinrichtung 12 ist vorzugsweise durch ein elektro-thermisches System 46 ausgebildet, das als Subsystem des hybriden Enteisungssystems 44 ausgebildet ist.

Die Wärmeabgabeeinrichtung 12 weist in einer bevorzugten Ausgestaltung einen Heizdraht 48 zur definierten Bildung einer Sollbruchstelle an der Stagnationslinie 34 des Profils 36 auf.

Wie insbesondere aus Fig. 2 ersichtlich, wird hierzu zum Aufbauen der Vorrichtung 10 im Bereich der Vorderkante 26 des Profilkörpers 18, der beispielsweise zum Bilden des Flügels 22 oder zum Bilden von Leitwerksflossen 24 oder zum Bilden eines Triebwerkseinlaufs 25 dient, der elektro-thermische Heizdraht 48 entlang der Stagnationslinie 34 des Profils 36 eingebaut. In bevorzugter Ausgestaltung wird der Heizdraht 48 in eine Matrix aus Befestigungsmaterial, wie insbesondere eine Epoxidharzmatrix 50, eingebettet.

Anstelle der Verwendung einer Einbettungsmatrix kann der Heizdraht 48 auch mit einem dünnen Folienkleber an der Innenseite des Profils 36 befestigt werden. Als bevorzugter Heizdraht 48 wird ein einadriger Mantelheizleiter mit schlankem, kreisrunden Querschnitt verwendet. Alternativ kann auch eine Kohlefaserkordel als Heizelement verwendet werden. Z.B. wird diese mit Epoxidharz getränkt und/oder zur elektrischen Isolierung mit Glaslagen umwickelt.

Anstelle des Heizdrahtes 48 kann die Wärmeabgabeeinrichtung 12 jedoch auch einen Piezoaktuator nutzen, der beispielsweise hochfrequent angesteuert wird und somit sowohl thermische als auch mechanische Energie abgibt. Ein solcher Piezoaktuator der hier nicht näher dargestellten weiteren Ausgestaltung ohne Heizdraht 48 sollte so ausgebildet sein, dass er die Wärme entlang der Wärmeabgabelinie 28 derart abgibt, dass eine Sollbruchstelle ausgebildet wird.

Die hier dargestellte Vorrichtung 10 weist neben der Wärmeabgabeeinrichtung 12 auch ein elektro-mechanisches Enteisungssystem 52 als weiteres Subsystem des hybriden Enteisungssystems 44 auf. Das elektro-mechanische Enteisungssystem 52 kann als ein Beispiel für die Verformungseinrichtung 40 angesehen werden. Vorzugsweise weist das elektro-mechanische Enteisungssystem 52 wenigstens einen Piezoaktuator 54 auf.

Besonders bevorzugt weist die Verformungseinrichtung 40 und deren elektro-mechanisches Enteisungssystem 52 eine erste Verformungseinheit 56 und eine zweite Verformungseinheit 57 auf. Die erste Verformungseinheit 56 dient zur Verformung eines ersten Abschnitts 38 des Oberflächenbereichs 14 auf einer ersten Seite der Wärmeabgabelinie 28. Bei dem in Fig. 2 dargestellten Beispiel, wo der Profilkörper 18 ein Teil des Flügels 22 ist, ist der erste Abschnitt 38 beispielsweise der oberhalb der Stagnationslinie 34 liegende Abschnitt des die Vorderkante 26 einschließenden Oberflächenbereichs 14. Dementsprechend wäre der zweite Abschnitt 39, der durch die zweite Verformungseinheit 57 zu verformen ist, in dem dargestellten Beispiel der unterhalb der Stagnationslinie 34 gelegene Abschnitt des Vorderkanten-Oberflächenbereichs 14.

Dementsprechend weist das elektro-mechanische Enteisungssystem 52 vorzugsweise wenigstens zwei Piezoaktuatoren 54, 55 auf, nämlich wenigstens einen ersten Piezoaktuator 54 für die erste Verformungseinheit 56 und wenigstens einen zweiten Piezoaktuator 55 für die zweite Verformungseinheit 57. Der erste und der zweite Abschnitt 38, 39 können insbesondere durch eine erste und eine zweite Längshälfte des Profilkörpers 18 gebildet sein.

Dementsprechend ist zum Beispiel zum Aufbau eines elektro-mechanischen Enteisungssystems 52 der Einbau von wenigstens zwei Piezoaktuatoren 54, 55 im Bereich einer Vorderkante 26 eines aerodynamischen Profils 36, wie beispielsweise dem Profilkörper 18 eines Flügels 22, vorgesehen. Die Piezoaktuatoren 54, 55 liegen in Strömungsrichtung hinter dem durch den Heizdraht 48 definierten linienförmigen Wärmeabgabebereich - Wärmeabgabelinie 28. Sie dienen damit zur Entfernung von Eisakkumulationen hinter dem Staupunkt des Profils 36 und zur Entfernung von Eisanlagerungen aus zurücklaufenden und erstarrenden Tropfen durch das elektro-thermische System 46.

Als Piezoaktuatoren 54, 55 können insbesondere dss-Aktuatoren, beispielsweise mit einer Länge von ca. 30 mm, einer Breite von ca. 10 mm und einer Höhe von ca. 2 mm eingesetzt werden. Für nähere Einzelheiten in Bezug auf den Aufbau der Piezoaktuatoren wird ausdrücklich auf die WO 2007/071231 A1 verwiesen.

Um eine möglichst effiziente mechanische Einkopplung in die Struktur zu ermöglichen, sind für die bevorzugten, quaderförmigen Piezoaktuatoren 54, 55 ebene Flächen 82 zur Applikation auf der Innenseite 76 des Profils 36 (z.B. des Flügelprofils 74) vorzusehen. Die bevorzugten, quaderförmigen Piezoaktuatoren sind insbesondere vorteilhaft, da sie als kostengünstige Standardbauteile erhältlich sind. Alternativ können auch formangepasste Piezoaktuatoren verwendet werden, welche die gleiche gekrümmte Kontur wie das Profil 36 vorweisen, um für eine möglichst effiziente mechanische Einkopplung in die Stuktur zu sorgen.

Die Vorrichtung 10 zur Enteisung und/oder Vermeidung von Eisbildung weist in der bevorzugten Ausgestaltung als hybrides Enteisungssystem 44 vorzugsweise auch eine Einrichtung zur Verminderung der Eisadhäsion an dem Oberflächenbereich 14 auf. Diese Einrichtung kann als weiteres Subsystem zur Enteisung angesehen werden. Insbesondere weist diese Einrichtung die Oberflächenbeschichtung 42 auf.

In bevorzugter Ausgestaltung wird der Oberflächenbereich 14 um die Vorderkante 26 des aerodynamischen Profils 36 oder zum Beispiel ein gesamter Oberflächenbereich des Profilkörpers 18 - beispielsweise der Flügel 22 - derart beschichtet, dass die Oberfläche minimale Adhäsionseigenschaften zwischen Eis (oder Wasser) und Profiloberfläche aufweist. Beispielsweise ist als Profilkörper 18 ein NACA-0012-Aluminium-Flügelprofil mit einer nanostrukturierten, superhydrophoben Oberflächenbeschichtung 42 im Bereich der Vorderkante 26 (z.B. Hydrobead) vorgesehen.

Fig. 2 zeigt demnach die bevorzugte Ausgestaltung der Vorrichtung 10 mit der mit dem Heizdraht 48 entlang der Stagnationslinie 34 versehenen Wärmeabgabeeinrichtung 12 als elektro-thermischem System 46, mit der mit Piezoaktuatoren 54, 55 gebildeten ersten und zweiten Verformungseinheit 56, 57 zum Verformen eines ersten Abschnitts und eines zweiten Abschnitts 38, 39 des Oberflächenbereichs 14 gebildeten Verformungseinrichtung 40 als elektro-mechanischem Enteisungssystem 52 und mit der Oberflächenbeschichtung 42 als weiterem Subsystem des hybriden Enteisungssystems 44.

Im Folgenden wird eine Funktionsweise eines derartigen hybriden Enteisungssystems 44 anhand der Darstellungen in den Fig. 3 und 4 näher erläutert.

Fig. 3 zeigt die Prinzipskizze des aerodynamischen Profils 36 am Beispiel des Profils des Flügels 22 mit einer vollständig durch Eis 30 bedeckten Vorderkante 26. Der angedeutete Heizdraht 48, welcher auf der Innenseite des Profils 36 auf Höhe der Stagnationslinie 34 aufgeklebt ist, wurde bei diesem Beispiel zu keiner Zeit elektro-thermisch beheizt. Selbst wenn nun durch Ansteuerung der angedeuteten piezoelektrischen Aktuatoren 54, 55 eine Bindung in der Grenzschicht zwischen Eis und der Oberfläche im Oberflächenbereich 14 des Profils 36 aufgebrochen wird, verbleibt die die Vorderkante 26 des Profils 36 umschließende Eisschicht dennoch an gleicher Stelle, da die aerodynamischen Kräfte der Strömung - dargestellt durch den Geschwindigkeitsvektor v - die Eisschicht weiterhin an die Vorderkante 26 des Profils 36 anpressen.

Dagegen zeigt die Fig. 4 eine Prinzipskizze des Profils 36 des beispielsweise den Flügel 22 bildenden Profilkörpers 18 mit - z.B. permanent - betriebenem Heizdraht 48, welcher auf der Innenseite des Profils 36 auf Höhe der Stagnationslinie 34 aufgeklebt ist. Das in zweidimensionaler Betrachtung punktuelle beziehungsweise in dreidimensionaler Betrachtung linienförmige Einbringen thermischer Energie generiert eine Sollbruchstelle beziehungsweise eine Sollbruchlinie 32, welche dem Zweck der Partitionierung beziehungsweise Aufspaltung der Akkumulation von Eis 30 an der Stagnationslinie 34 des Profils 36 des Flügels 22 in einen oberen Anteil 60 und einen unteren Anteil 61 der Eisschicht dient. Allgemeiner gesehen wird das Eis 30 entlang der Sollbruchlinie 32 in einen ersten Anteil 60 und einen zweiten Anteil 61 aufgeteilt. Dadurch können beide Eisanteile 60, 61 durch die angedeuteten piezoelektrischen Aktuatoren 54, 55 entfernt werden.

Die anhand den Fig. 3 und 4 ersichtliche Funktionsweise des hybriden Enteisungssystems 44 wird hiernach noch in näheren Einzelheiten am Beispiel einer möglichen Ausgestaltung eines - beispielsweise mit der Vorrichtung 10 durchführbaren - Verfahrens zur Enteisung oder zur Vermeidung von Eisbildung an Luftfahrzeugen näher erläutert.

Durch die Verwendung zum Beispiel eines Heizdrahtes 48 an der Stagnationslinie 34 des Profils 36 eines Flügels 22 oder dergleichen, welcher Heizdraht 48 auf die Innenseite des Profils 36 aufgeklebt ist, wird thermische Energie in Spannweitenrichtung linienförmig an das Profil 36 übertragen. Allgemeiner erfolgt eine Wärmeabgabe einer Wärmeabgabeeinrichtung 12 bei dreidimensionaler Betrachtung linienförmig beziehungsweise punktuell bei zweidimensionaler Betrachtung wie in Fig. 4 dargestellt. Dies bedingt ein Aufschneiden der die Vorderkante 26 umschließenden Schicht Eis 30 und kann als bewusstes Einbringen einer Sollbruchstelle oder Sollbruchlinie 32 angesehen werden, welche dem Zweck der Partitionierung der Eisakkumulation in eine erste und eine zweite Eishälfte - zum Beispiel in eine obere Eishälfte und eine untere Eishälfte - dient.

Von besonderem Vorteil ist die gemeinsame Verwendung eines Heizdrahtes 48 zum Bilden des hybriden Enteisungssystems 44 in Kombination mit einer Verformung eines Oberflächenbereichs 14 des Profils 36 durch piezoelektrische Aktuatoren 54, 55.

Verzichtet man auf den Einsatz des Heizdrahtes 48, sind die Piezoaktuatoren 54, 55 zwar in der Lage, die Oberfläche des Profils 36 des Flügels 22 zu verformen und somit die Bindung in der Grenzfläche von Eis und Oberfläche aufzubrechen. Das von der Oberfläche gelöste Eis 30 wird jedoch aufgrund des aerodynamischen Staudrucks der Anströmung weiterhin an das Profil 36 des Flügels 22 angepresst. Somit wird der Oberflächenbereich 14 nicht final von Eisakkumulation befreit - siehe Fig. 3. durch die Partitionierung in mehrere Abschnitte oder Anteile 60, 61, zum Beispiel eine obere und eine untere Eishälfte, mit der Wärmeabgabeeinrichtung 12, beispielsweise mittels des Heizdrahtes 48, wird ein mögliches Problem eines Anpressens des Eises 30 an das Profil 36 umgangen - siehe hierzu Fig. 4 - und man kann sich zusätzlich den Effekt der aerodynamischen Anströmung des Profils 36 und der dadurch auf das Eis 30 wirkenden Kräfte zunutze machen.

Somit dient der Heizdraht 48 - im Gegensatz zu elektro-thermischen Systemen oder Wärmeabgabeeinrichtungen, die mit Heizmatten arbeiten - nicht zur großflächigen thermischen Entfernung von Eisakkumulationen auf dem aerodynamischen Profil 36, wie beispielsweise des Flügels 22, sondern zum linienförmigen Aufbrechen der Eisschicht.

Dementsprechend weist ein zum Beispiel mit der Vorrichtung 10 durchführbares Enteisungsverfahren zur Enteisung eines Oberflächenbereichs 14 eines Luftfahrzeuges 16 und/oder zum Vermeiden von Eisbildung an dem Oberflächenbereich 14 des Luftfahrzeuges 16 den Schritt Einbringung von Wärme entlang einer Linie an dem Oberflächenbereich 14 auf, um eine Sollbruchlinie 32 in sich an dem Oberflächenbereich 14 ansammelndem Eis 30 oder eine Trennlinie in sich an dem Oberflächenbereich ansammelnden Eis oder in sich an dem Oberflächenbereich akkumulierenden Wassertropfenansammlungen zu bilden.

Unter geschickter Ausnutzung der Anströmung kann so eventuell durch das Aufbrechen von Eis entlang einer Sollbruchlinie eine Eisentfernung stattfinden.

Mehr bevorzugt wird das Einbringen von Wärme entlang einer Wärmeabgabelinie 28 zum Bilden einer Sollbruchlinie 32 oder Trennlinie entlang einer Stagnationslinie 34 eines aerodynamischen Profils 36 durchgeführt.

Mehr bevorzugt weist das Enteisungsverfahren weiter noch wenigstens einen der Schritte Verformen des Oberflächenbereichs 14, um Eis entlang der Sollbruchlinie 32 aufzubrechen und/oder um entlang der Sollbruchlinie 32 aufgebrochenes Eis oder sich auf den Seiten der Trennlinie akkumulierende Wasseransammlungen zu entfernen und/oder Vorsehen eines Oberflächenbereichs 14 mit einer Eisadhäsionskräfte herabsetzenden Oberflächenbeschaffenheit - insbesondere mittels einer entsprechenden Oberflächenbeschichtung 42 - auf.

In bevorzugter Ausgestaltung wird der Heizdraht 48 des elektro-thermischen Systems 46 im permanenten Running-Wet-Anti-Icing-Modus betrieben. Für einen niedrigeren Energieverbrauch kann der Heizdraht aber auch alternativ im zyklischen De-Icing-Modus betrieben werden, um das Entfernen der voneinander getrennten Anteile 60, 61 von Eis 30 auf dem Profil 36 mittels der Verformungseinrichtung 40 zu ermöglichen.

Die Verformung des Oberflächenbereichs 14 erfolgt vorzugsweise durch Piezoaktuatoren 54, 55. Insbesondere erfolgt die Verformung der Oberfläche des Profils 36 durch Ansteuerung der Piezoaktuatoren 54, 55 im Bereich der Resonanzfrequenz der Struktur - hier wird vorzugsweise eine niedrige Ansteuerspannung bei einer Aufsetzspannung von 0 V eingesetzt - oder durch eine quasi-statische Anregung der Piezoaktuatoren - hier wird eine hohe Amplitude bei einer Aufsetzspannung >0 V vorzugsweise eingesetzt -, wodurch die Eisakkumulationen im Bereich in Strömungsrichtung hinter der Stagnationslinie 34 des Profils 36 entfernt werden.

Eine weitere mögliche Ansteuerung liegt in einer kontinuierlichen, dynamischen Ansteuerung der piezoelektrischen Aktuatoren 54, 55 mit einem Rechtecksignal mit definierter Flankensteilheit bei einer Wiederholfrequenz von beispielsweise 1 Hz. Über das Rechtecksignal wird die Flügelstruktur in Resonanz versetzt, dieser Effekt wirkt sich zu der statischen Auslenkung weiter positiv auf das Abplatzen des Eises 30 aus.

Bei Einbau von beispielsweise zwei oder mehreren Piezoaktuatoren 54, 55 jeweils auf dem ersten und dem zweiten Abschnitt 38, 39 des Profils 36 - beispielsweise auf der Oberseite und der Unterseite des Profils 36 des Flügels 22 - besteht des Weiteren die Möglichkeit, die Aktuatoren 54, 55 einzeln anzusteuern, um eine beliebige Schwingungsform auf der Oberfläche des Profils 36 zu erzeugen, beispielsweise eine Art Welle quer zur Oberfläche des Oberflächenbereichs 14.

Die Bewegungsrichtung der Piezoaktuatoren 54, 55 kann in Spannweitenrichtung oder Flugrichtung (d₃₃-Effekt) oder flächig (d₃₁-Effekt) erfolgen.

Durch die eisphoben Eigenschaften einer super-hydrophoben Beschichtung 42 werden die adhäsiven Bindungskräfte zwischen Eis 30 und der Oberfläche des Profils 36 auf ein Minimum reduziert. Dadurch wird eine energieeffiziente Entfernung aller Eisakkumulationen an dem Profil 36 ermöglicht.

Zum Funktionsnachweis wurde ein Vereisen eines Profils 36 des Flügels 22 unter realen Flugbedingungen in einem Vereisungswindkanal in Labormaßstab durchgeführt. Durch Verwendung aller drei Subsysteme des hybriden Enteisungssystems 44 wurden alle auf dem Flügelprofil anhaftenden Eisackumulationen entfernt. Die drei Subsysteme wurden dabei gleichzeitig eingesetzt. Ein Vergleich des Energiebedarfs des hybriden Enteisungssystems 44 mit einem bereits für den Flugbetrieb zertifizierten Enteisungssystem - insbesondere einem rein elektro-thermischen Enteisungssystem - konnte eine sehr deutliche Energieeinsparung aufzeigen.

Weitere Ausführungsbeispiele und Abwandlungen der Vorrichtung 10 befassen sich mit einer Erniedrigung der Ausfallwahrscheinlichkeit.

So könnte die Wärmeabgabeeinrichtung 12 zur Sicherstellung der Redundanz eines hybriden Enteisungssystems 44 eine Mehrzahl von Heizdrähten 48 aufweisen.

Beispielsweise könnte ein Heizdraht 48 unmittelbar an der Stagnationslinie 34 vorgesehen sein und weitere Heizdrähte (nicht näher dargestellt) werden im Bereich um die Stagnationslinie 34 angeordnet.

Auch können jeweils mehrere Piezoaktuatoren 54, 55 auf den jeweiligen Abschnitten 38, 39 verwendet werden.

Derartige Vorrichtungen 10 sind zum Durchführen besonders energieeffizienter Verfahren zum Enteisen bzw. zum Vermeiden von Eisbildung geeignet. Hierzu ist jedoch ein elektro-mechanisches Enteisungssystem 52 vorteilhaft, welches eine Verformung eines möglichst nahe der Vorderkante liegenden Oberflächenbereichs des Profilkörpers 18 ermöglicht.

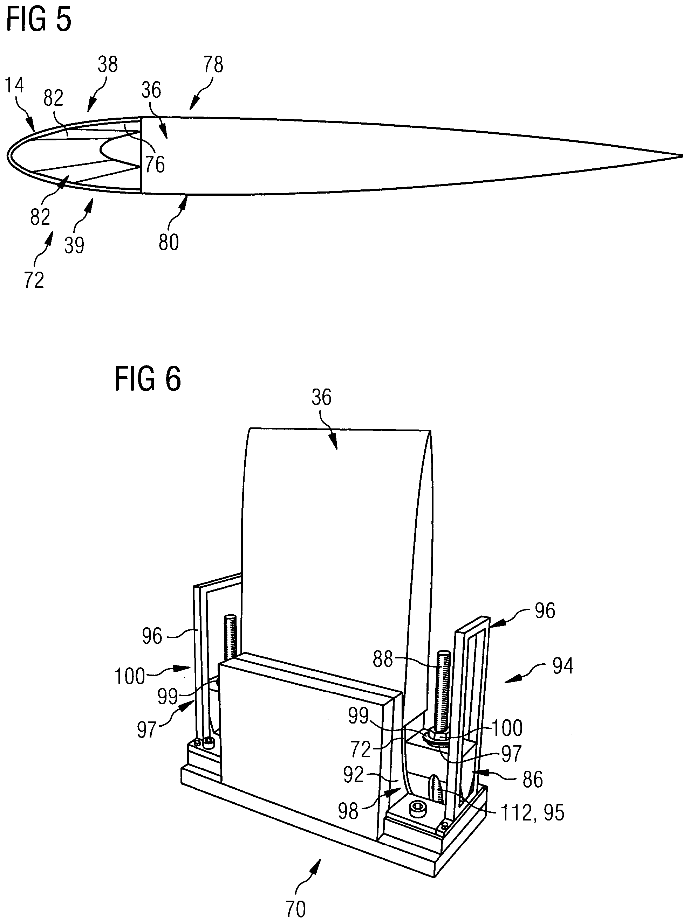

Im Folgenden werden anhand der Darstellungen in den Fig. 5 bis 10 eine Montagevorrichtung 70 und ein Aktuatormontageverfahren zum Montieren von Aktuatoren 54, 55 näher erläutert, das eine derartige Anbringung erlaubt. Wenngleich die Montagevorrichtung 70 und das Aktuatormontageverfahren zu Darstellungszwecken anhand des Ausführungsbeispiels einer hybriden Vorrichtung 10 erläutert wird, so ist die Anwendbarkeit nicht darauf beschränkt. Sie können insbesondere überall dort eingesetzt werden, wo eine Verformung einer stark gekrümmten oder einen engen Raum einschließenden Schalenstruktur 72 mittels Akutatoren stattfinden soll.

Das Aktuatormontageverfahren ist zum Montieren wenigstens eines Aktuators 54, 55 geeignet und wird insbesondere zum Herstellens einer mechanischen Eisschutzeinrichtung 37 - z.B. das elektro-mechanische Enteisungssystem 52 - für ein Luftfahrzeug 16 zum Vermeiden einer Eisbildung an dem Oberflächenbereich 14 und/oder Enteisen des Oberflächenbereichs 14 des Luftfahrzeuges 16 verwendet. Das Aktuatormontageverfahren umfasst insbesondere die Schritte:
a) Bereitstellen einer Schalenstruktur 72, an deren Außenseite der zu enteisenden Oberflächenbereich 14 auszubilden ist,
b) Bereitstellen wenigstens eines Aktuators 54, 55, der zur Verformung des Oberflächenbereichs 14 der Schalenstruktur 72 geeignet ist, und
c) Befestigen des wenigstens einen Aktuators 54, 55 an der Innenseite der Schalenstruktur 72.

Bei dem Beispiel der in der Fig. 2 gezeigten Vorrichtung 10 ist eine Grundvorraussetzung für die Montage der Piezoaktuatoren 54, 55 die Fertigung einer dünnen Schalenstruktur 72, mit welcher die Piezoaktuatoren 54, 55 verklebt werden.

In diesem Beispiel wird ein NACA-0012-Flügelprofil verwendet, welches aus dem Vollen gefräst wurde. Fig. 5 zeigt die Schalenstruktur 72 des Profils 36 des Profilkörpers 18. Es handelt sich um ein z.B. aus dem Vollen gefrästes Profil 36 für einen Flügel 22 in Form eines symmetrischen schlanken NACA 0012 Profils. Selbstverständlich ist das Montageverfahren auch auf jedes andere Profil 36 der möglichen Profilkörper 18 des Luftfahrzeuges anwendbar.

An der Innenseite 76 der Schalenstruktur 72 sind im Bereich einer ersten Längshälfte 78 und einer zweiten Längshälfte 80 jeweils eine ebene Fläche 82 zur späteren Verklebung der vorzugsweise quaderförmigen piezoelektrischen Multilayer-Aktuatoren gebildet.

Die Oberfläche an der Innenseite 76 des Profils 36, wo die Piezoaktuatoren 54, 55 später verklebt werden, sollte einen geeigneten Rauhigkeitswert haben und vor der weiteren Verwendung gereinigt sein. Des Weiteren ist in diesem Bereich eine (vorzugsweise) ebene Fläche 82 vorzusehen.

Der Aktuator 54, 55 kann auch alternativ auf eine gekrümmte Schalenstruktur 72 aufgeklebt werden. In diesem Fall weisen die Schalenstruktur 72 und der Aktuator 54, 55 bevorzugt die gleiche Krümmung auf.

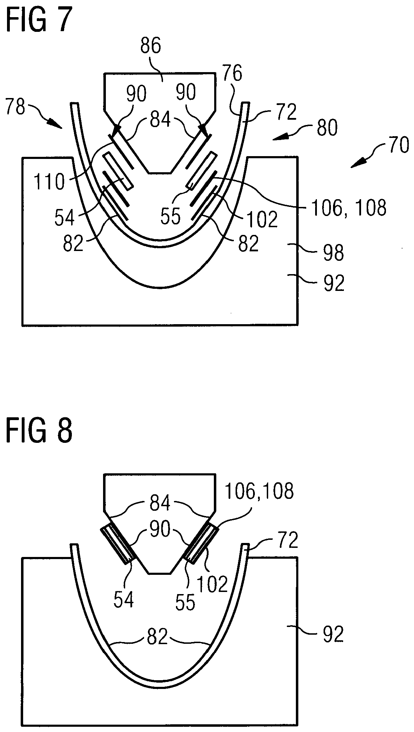

Anschließend wird zum Montieren der Aktuatoren 54, 55 eine Montagevorrichtung 70 verwendet, wie sie z.B. in einem schematischen Demonstrationsaufbau in Fig. 6 gezeigt und in den Fig. 7 bis 10 angedeutet ist.

Die Montagevorrichtung 70 weist einen Stempel 86, eine Anpresseinrichtung 88, Haltemittel 90 und eine Stützform 92 auf.

Der Stempel 86 dient zum Aufnehmen und Anpressen der Aktuatoren 54, 55 an die Innenseite 76 der Schalenstruktur 72.

Der Stempel 86 weist hierzu einen Aufnahmebereich 84 auf, dessen Oberflächenform komplementär zu dem Teil der Oberflächenstruktur der Innenseite 76 ausgebildet ist, an dem die Aktuatoren 54, 55 zu befestigen sind. Sind z.B. die ebenen Flächen 82 vorgesehen, ist der Aufnahmebereich 84 mit mit entsprechenden Winkel geneigten ebenen Flächen ausgebildet. Hierzu kann der Stempel 86 z.B. insgesamt trapezförmig ausgebildet sein. Die Haltemittel 90 sind zum temporären Halten der Aktuatoren 54, 55 an dem Stempel 86 ausgebildet.

Die Anpresseinrichtung 88 dient zum Anpressen des Stempels 86 an die Innenseite 76. Hierzu ist insbesondere eine Führungseinrichtung 94 und Druckkrafterzeugungseinrichtung 95 zum geführten Bewegen des Stempels 86 und Anpressen vorgesehen. Zum Aufrechterhalten eines konstanten Drucks ist insbesondere ein Kraftspeicherelement, wie z.B. eine Tellerfeder 97 vorgesehen.

Die Stützform 92 dient zum Abstützen der dünnen Schalenstruktur 72 während des Anpressens. Hierzu ist die Oberfläche der Stützform 92 komplementär zu dem Oberflächenbereich 14 der Schalenstruktur 72 ausgebildet.

Fig. 6 zeigt einen Demonstrationsaufbau einer Montagevorrichtung 70 für die Montage von Aktuatoren an einem kleinskaligen Profil 36 für Windkanalversuche. Dargestellt sind das Profil 36, seitliche Führungsschienen 96 zum Bilden der Führungseinrichtung 94, der Stempel 86 mit daran anhaftenden Piezoaktuatoren 54, 55, eine Polyamidform 98 als Beispiel für die Stützform 92 sowie Muttern 100 für die Montage. Die Druckkrafterzeugungseinrichtung 95 weist Gewindestangen 112 auf. Mittels Schraubendrehern (nicht dargestellt) können die Muttern 100 an den Gewindestangen 112 in Richtung auf die Innenseite 76 zu gedreht werden, um den Stempel 86 gegen die Innenseite 76 zu drücken. Zwischen den Muttern 100 und dem Stempel 86 sind die Tellerfedern 97 als Kraftspeicherelemente zum Aufrechterhalten des konstanten Drucks vorgesehen. Es können auch Unterlegscheiben 99 vorgesehen sein, die zwischen der Mutter 100 und der Tellerfeder 97 angeordnet sein.

Im Folgenden wird der Klebeprozess anhand der Darstellung der Fig. 7 bis 10 näher erläutert.

Stehen die Schalenstruktur 72 und die Aktuatoren 54, 55 bereit, wird zunächst der Schritt Applikation der Aktuatoren 54, 55 am Stempel 86 durchgeführt. Ein Ausführungsbeispiel dieses Schritts der Applikation oder der Anbringung der Aktuatoren am Stempel 86 wird hiernach näher erläutert.

Es wird ein Klebemittel 102 zum Verkleben der Aktuatoren mit der Innenseite auf die Aktuatoren aufgetragen.

Hierzu wird z.B. in einer bevorzugten Ausgestaltung eine dünne Schicht eines Folienklebers 104 zurechtgeschnitten und auf die Seite des Piezoaktuators 54, 55 aufgebracht, welche später mit dem Profil 36 verbunden werden soll.

Falls die Innenseite des Profils 36 elektrisch leitend ist, wird zwischen der Innenseite und den Aktuatoren 54, 55 eine Isolationsschicht 106 aus einem elektrisch isolierenden Material vorgesehen.

Hierzu wird, falls das Profil elektrisch leitend ist, zur elektrischen Isolierung von der Trägerstruktur beispielsweise ein Prepreg-Glasfasergewebe 108 zum Bilden der Isolationsschicht 106 vorgesehen. Der benötigte Isolationsabstand wird über die Anzahl der Prepreg-Lagen eingestellt. Je höher die elektrische Ansteuerspannung gewählt wird, desto größer wird der Isolationsabstand gewählt.

Auf den Stempel 86, der hier mit trapezförmigem Querschnitt versehen ist, wird beidseitig je ein Piezoaktuator 54, 55 mit dem Haltemittel 90, das beispielsweise ein anhaftendes Medium aufweist, wie beispielsweise ein doppelseitiges Klebeband 110 für eine temporäre Verklebung zur späteren Lösbarkeit nach dem Klebeprozess, oder zum Anhaften mit einem physikalischen Prinzip ausgebildet ist (z.B. Ansaugen über Vakuum oder elektrostatische Aufladung), appliziert oder angehaftet.

Bei Verwendung von empfindlichen Piezoaktuatoren 54, 55 ist es vorteilhaft, wenn keine punktuellen Querkräfte auf die Fläche des Piezoaktuators 54, 55 aufgebracht werden. Aufgrund dessen hat sich ein doppelseitiges Klebeband 110 als Haltemittel 90 besonders geeignet herausgestellt.

Damit wird die spätere Positionierung der Piezoaktuatoren 54, 55 innerhalb des Profils 36 über die Positionierung der Piezoaktuatoren 54, 55 auf dem Stempel 86 festgelegt. Z.B. können die Piezoaktuatoren 54, 55 über Markierungen auf dem Stempel 86, über Anschläge auf dem Stempel oder eine sonstige zusätzliche Ausrichteinrichtung (alle nicht dargestellt) ausgerichtet werden.

Nach dem Anbringen der Aktuatoren 54, 55 auf dem Stempel 86 kann der Schritt stoffschlüssiges Verbinden, insbesondere Verkleben, der Aktuatoren 54, 55 mit der Schalenstruktur 72 erfolgen, der hiernach näher erläutert wird.

Zur exakten Positionierung und zur Einhaltung des Winkels vom Stempel 86 innerhalb des Profils 36 ist es vorteilhaft, wenn der Stempel 86 geführt ist, z.B. mit Führungsschienen 96 und Gewindestangen 112. Der Stempel 86 kann entweder beidseitig seitlich, einseitig seitlich oder bei offenen Profilen auch von hinten geführt werden.

Der Anpressdruck sollte über den Klebeschritt während des Aushärtens des Klebemittels 102 konstant gehalten werden. Dies kann beispielsweise mittels Kraftspeicherelemente wie z.B. Tellerfedern (nicht dargestellt) erreicht werden. Der Anpressdruck wird mit einer Negativ-Form - Stützform 92 - des Profils 36 (z.B. aus Polyamid gefertigt) gegengehalten, um die Form des Profils 36 aufrecht zu erhalten.

Zum Aushärten des Klebemittels 102 ist eine Aushärteeinrichtung vorgesehen, die zum Durchführen des für das jeweilige Klebemittel 102 durchzuführenden Aushärtschritts ausgebildet ist.

Zum Beispiel erfolgt der Aushärtevorgang des Klebemittels 102 in einem Ofen (nicht dargestellt) bei geeigneter Temperatur, vorzugsweise unterhalb der Curie-Temperatur (120°C). Zur Einhaltung der Temperatur kann diese z.B. mit einer Kontrollbohrung nahe der Positionierungsstelle des Piezoaktuators am Stempel 86 kontrolliert werden.

Durch die Aushärtung bei geeigneter Temperatur, kann wie benötigt oder gewünschet eine mechanische Vorspannung eingebracht werden. Die mechanische Vorspannung schützt den Aktuator besser vor Zugspannung und/oder vor Defekten, wie sie insbesondere im Resonanzbetrieb auftreten können.

Optional kann zusätzlich mit dem gleichen Prinzip der Heizdraht 48 an der Innenseite 76 des Profils 36 im Bereich der Stagnationslinie 34 mit verklebt werden.

Im Folgenden wird der Schritt Entfernen des Stempels 86 nach dem Verkleben der Piezoaktuatoren 54, 55 mit dem Profil 36 näher erläutert.

Nach der Verklebung der Piezoaktuatoren 54, 55 wird der Anpressdruck gelöst und der Stempel 86 kann entfernt werden. Bei Verwendung eines doppelseitigen Klebebands 110 erweist sich eine vereinfachte Entnahme des Stempels 86 im warmen Zustand als besonders geeignet, da nur ein geringer Kraftaufwand zum Lösen des Klebebandes 110 von den Piezoaktuatoren 54, 55 benötigt wird.

Fig. 7 zeigt schematisch die beim Applikationsprozess der Aktuatoren an der Schalenstruktur verwendeten Komponenten.

Fig. 8 zeigt schematisch den Schritt der Applikation der Aktuatoren 54, 55 an dem Stempel und das Einfahren des Stempels 86 in das Profil 36.

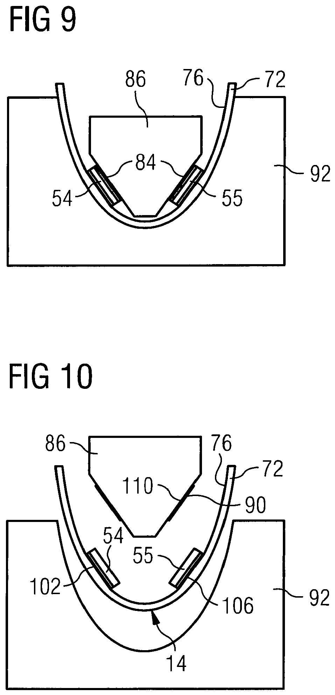

Fig. 9 zeigt schematisch den Schritt des Anpressens des Stempels 86.

Fig. 10 zeigt schematisch den Schritt des Abziehens des Stempels 86.

Neben der dargestellten möglichen Verwendung des Aktuatormontageverfahrens im Zuge der Herstellung von Eisschutzsystemen kann das Verfahren auch zur Montage von Aktuatoren zu anderen Einsatzzwecken verwendet werden. Beispiele hierfür sind in der WO 2007/071231 A1 aufgezeigt, auf die ausdrücklich für weitere Einzelheiten der weiteren möglichen Einsatzzwecke verwiesen wird.

### Bezugszeichenliste:

- 10: Vorrichtung zur Enteisung und/oder Vermeidung von Eisbildung
- 12: Wärmeabgabeeinrichtung
- 14: Oberflächenbereich
- 16: Luftfahrzeug
- 18: Profilkörper
- 20: Flugzeug
- 22: Flügel
- 24: Leitwerksflossen
- 25: Triebwerkseinlauf
- 26: Vorderkante
- 28: Wärmeabgabelinie
- 30: Eis
- 32: Sollbruchlinie (Trennlinie)
- 34: Stagnationslinie
- 36: Profil
- 37: Eisschutzeinrichtung
- 38: erster Abschnitt
- 39: zweiter Abschnitt
- 40: Verformungseinrichtung
- 42: Oberflächenbeschichtung
- 44: hybrides Enteisungssystem
- 46: elektro-thermisches System
- 48: Heizdraht
- 50: Epoxidharzmatrix
- 52: elektro-mechanisches Enteisungssystem
- 54: erster Piezoaktuator
- 55: zweiter Piezoaktuator
- 56: erste Verformungseinheit
- 57: zweite Verformungseinheit
- 60: erster Anteil der Eisschicht
- 61: zweiter Anteil der Eisschicht
- 70: Montagevorrichtung
- 72: Schalenstruktur
- 76: Innenseite
- 78: erste Längshälfte
- 80: zweite Längshälfte
- 82: ebene Fläche
- 84: Aufnahmebereich
- 86: Stempel
- 88: Anpresseinrichtung
- 90: Haltemittel
- 92: Stützform
- 94: Führungseinrichtung
- 95: Druckkrafterzeugungseinrichtung
- 96: seitliche Führungsschiene
- 97: Tellerfeder
- 98: Polyamidform
- 99: Unterlegscheibe
- 100: Mutter
- 102: Klebemittel
- 104: Folienkleber
- 106: Isolationsschicht
- 108: Prepreg-Glasfasergewebe
- 110: beidseitiges Klebeband
- 112: Gewindestangen
- 60: erster Anteil der Eisschicht
- 61: zweiter Anteil der Eisschicht
- 70: Montagevorrichtung
- 72: Schalenstruktur
- 76: Innenseite
- 78: erste Längshälfte
- 80: zweite Längshälfte
- 82: ebene Fläche
- 84: Aufnahmebereich
- 86: Stempel
- 88: Anpresseinrichtung
- 90: Haltemittel
- 92: Stützform
- 94: Führungseinrichtung
- 95: Druckkrafterzeugungseinrichtung
- 96: seitliche Führungsschiene
- 97: Tellerfeder
- 98: Polyamidform
- 99: Unterlegscheibe
- 100: Mutter
- 102: Klebemittel
- 104: Folienkleber
- 106: Isolationsschicht
- 108: Prepreg-Glasfasergewebe
- 110: beidseitiges Klebeband
- 112: Gewindestangen

## Patentansprüche

1. Aktuatormontageverfahren zum Montieren wenigstens eines Aktuators (54, 55) in einer stark gekrümmten oder einen engen Raum einschließenden Schalenstruktur eines Profils (36) eines Profilkörpers (18) eines Luftfahrzeuges, umfassend die Schritte:
a) Bereitstellen der Schalenstruktur (72),
b) Bereitstellen wenigstens eines Aktuators (54, 55), der zur Verformung eines Oberflächenbereichs (14) der Schalenstruktur (72) geeignet ist, durch Bereitstellen wenigstens eines ersten Aktuators (54) zur Verformung eines auf einer ersten Längshälfte (78) der Schalenstruktur (72) ausgebildeten Abschnitts (38) des Oberflächenbereichs (14) und Bereitstellen wenigstens eines zweiten Aktuators (55) zur Verformung eines auf einer zweiten Längshälfte (80) der Schalenstruktur (72) ausgebildeten Abschnitts (39) des Oberflächenbereichs (14), und
c) Befestigen des wenigstens einen Aktuators (54, 55) an einer Innenseite (76) der Schalenstruktur (72) durch gleichzeitiges Befestigen des wenigstens einen ersten Aktuators (54) an der Innenseite der ersten Längshälfte (78) und des wenigstens einen zweiten Aktuators (80) an der Innenseite der zweiten Längshälfte (80),
**dadurch gekennzeichnet, dass** Schritt c) enthält:
c1) Anordnen des wenigstens einen Aktuators (54, 55) an einem Stempel (86) zum flächigen Anpressen des wenigstens einen Aktuators (54, 55) an der Innenseite der Schalenstruktur (72),
c2) Anhaften des Aktuators (54, 55) an den Stempel (86) mittels eines lösbaren Haltemittels (90),
c3) Anpressen des Aktuators (54, 55) an die Innenseite der Schalenstruktur (72) innerhalb des Profils (36) mittels des Stempels (86), c4) Verbinden des Aktuators (54, 55) mit der Innenseite (76),
c5) Lösen und/oder Entfernen des Stempels (86).

2. Aktuatormontageverfahren nach Anspruch 1,
**dadurch gekennzeichnet,**
**dass** Schritt c4) wenigstens einen der folgenden Schritte enthält:
c4.1) stoffschlüssiges Verbinden der Aktuatoren (54, 55) mit der Innenseite (76);
c4.2) großflächiges oder vollflächiges Verkleben der Aktuatoren (54, 55) mit der Innenseite (76);
c4.2.1) Auftragen eines Klebemittels (102) auf die Innenseite (76) und/oder eine mit der Innenseite (76) zu verklebende Fläche der Aktuatoren (54, 55) vor dem Anbringen der Aktuatoren (54, 55) an die Innenseite (76),
c4.2.2) Aushärten des Klebemittels (102) unter Anpressen der Aktuatoren (54, 55) gemäß Schritt c3); und/oder
c4.3) Zwischenlage einer elektrischen Isolationsschicht (106) zwischen Aktuator (54, 55) und Innenseite (76).

3. Aktuatormontageverfahren nach einem der voranstehenden Ansprüche, **dadurch gekennzeichnet,**
**dass** Schritt c2) enthält:
c2.1) Halten der Aktuatoren (54, 55) mittels zweiseitigen Klebebands (110) an dem Stempel während des Einbringens in die Schalenstrukur (72) und/oder des Anbringens an die Schalenstruktur (72).

4. Aktuatormontageverfahren nach einem der voranstehenden Ansprüche, **dadurch gekennzeichnet,**
**dass** Schritt c3) den Schritt enthält:
c3.1) geführtes Bewegen des Stempels (86) durch eine Führungseinrichtung (94).

5. Aktuatormontageverfahren nach einem der voranstehenden Ansprüche, **dadurch gekennzeichnet,**
**dass** Schritt c3) wenigstens einen der Schritte enthält:
c3.2) Aufrechterhalten und/oder Konstanthalten eines Pressdrucks mittels eines
Kraftspeichers, wie z.B. Tellerfeder, und/oder
c3.3) Abstützen der Außenseite der Schalenstruktur (72) mittels einer zu der Außenseite komplementären Stützform (92).

6. Aktuatormontageverfahren nach einem der voranstehenden Ansprüche, **dadurch gekennzeichnet,**
**dass** Schritt a) enthält:
Bereitstellen der Schalenstrukur (72) mit wenigstens einer ebenen Fläche (82) auf der Innenseite (76) der Schalenstrukur (72) und dass Schritt c) enthält:
Befestigen des wenigstens einen ersten Aktuators (54) und des wenigstens einen zweiten Aktuators (55) an der wenigstens einen ebenen Fläche (82).

7. Aktuatormontageverfahren nach einem der voranstehenden Ansprüche, **dadurch gekennzeichnet,**
**dass** Schritt b) enthält:
b.1) Bereitstellen wenigstens eines piezoelektrischen Aktuators (54, 55).

8. Herstellverfahren zum Herstellen einer mechanischen Eisschutzeinrichtung (37) für ein Luftfahrzeug zum Freihalten von Eis und/oder Enteisen eines Oberflächenbereichs (14) des Luftfahrzeuges (16) mittels Durchführen eines Aktuatormontageverfahrens nach einem der voranstehenden Ansprüche, wobei die Schalenstruktur (72) an deren Außenseite den von Eis freizuhaltenden und/oder zu enteisenden Oberflächenbereich (14) aufweist.

9. Herstellverfahren zum Herstellen einer hybriden Eisschutzvorrichtung (10) für ein Luftfahrzeug, zum thermischen und mechanischen Freihalten von Eis und/oder Enteisen eines Oberflächenbereichs (14), umfassend:
Durchführen eines Herstellverfahrens zum Herstellen einer mechanischen Eisschutzeinrichtung (37) für ein Luftfahrzeug zum Freihalten von Eis und/oder Enteisen eines Oberflächenbereichs (14) des Luftfahrzeuges (16) nach Anspruch 8 und durch den Schritt:
d) Anbringen einer Wärmeabgabeeinrichtung (12) zum Erwärmen zumindest eines Teils der Schalenstruktur (72).

10. Herstellverfahren nach Anspruch 9,
**dadurch gekennzeichnet,**
**dass** Schritt d) enthält:
d1) Bereitstellen einer Wärmeabgabeeinrichtung (12), die zur linienförmigen Wärmeabgabe zwecks Erzeugung einer Sollbruchstelle oder Sollbruchlinie (32) oder Trennlinie in sich auf dem Oberflächenbereich (14) ansammelndem Eis ausgebildet ist, und
d2) Anbringen der Wärmeabgabeeinrichtung (12) an der Innenseite (76) der Schalenstruktur im Bereich einer Vorderkante (26) und/oder einer Stagnationslinie (34) eines durch die Schalenstruktur (72) zu bildenden Profilkörpers (18).

## Claims

1. Actuator installation method for mounting at least one actuator (54, 55) in a highly curved shell structure, or shell structure enclosing a narrow space, of a profile (36) of a profile body (18) of an aircraft, comprising the steps of:
a) providing the shell structure (72),
b) providing at least one actuator (54, 55), which is suitable for deforming a surface region (14) of the shell structure (72), by providing at least one first actuator (54) for deforming a portion (38) of the surface region (14) formed on a first longitudinal half (78) of the shell structure (72) and providing at least one second actuator (55) for deforming a portion (39) of the surface region (14) formed on a second longitudinal half (80) of the shell structure (72), and
c) fastening the at least one actuator (54, 55) to an inner side (76) of the shell structure (72) by simultaneously fastening the at least one first actuator (54) to the inner side of the first longitudinal half (78) and the at least one second actuator (80) to the inner side of the second longitudinal half (80),
**characterized in that** step c) comprises:
c1) arranging the at least one actuator (54, 55) on a punch (86) for pressing the at least one actuator (54, 55) flat against the inner side of the shell structure (72),
c2) sticking the actuator (54, 55) onto the punch (86) by means of a releasable retaining means (90),
c3) pressing the actuator (54, 55) onto the inner side of the shell structure (72) within the profile (36) by means of the punch (86),
c4) connecting the actuator (54, 55) to the inner side (76),
c5) releasing and/or removing the punch (86).

2. Actuator installation method according to Claim 1, **characterized**
**in that** step c4) comprises at least one of the following steps:
c4.1) connecting the actuators (54, 55) to the inner side (76) in an integrally bonded manner;
c4.2) adhesively bonding the actuators (54, 55) to the inner side (76) over a large surface area or full surface area;
c4.2.1) applying an adhesive (102) to the inner side (76) and/or to a surface of the actuators (54, 55) to be adhesively bonded to the inner side (76) before the actuators (54, 55) are attached to the inner side (76),
c4.2.2) curing the adhesive (102) by the actuators (54, 55) being pressed on as per step c3); and/or
c4.3) positioning an electric insulation layer (106) between the actuator (54, 55) and inner side (76).

3. Actuator installation method according to either of the preceding claims, **characterized**
**in that** step c2) comprises:
c2.1) holding the actuators (54, 55) on the punch by means of double-sided adhesive tape (110) as they are being introduced into the shell structure (72) and/or attached to the shell structure (72).

4. Actuator installation method according to one of the preceding claims, **characterized**
**in that** step c3) comprises the step of:
c3.1) guided moving of the punch (86) by means of a guide device (94).

5. Actuator installation method according to one of the preceding claims, **characterized**
**in that** step c3) comprises at least one of the steps of:
c3.2) maintaining and/or keeping a pressing pressure constant by means of a force accumulator, e.g. disc spring, and/or
c3.3) supporting the outer side of the shell structure (72) by means of a supporting shape (92) complementary with respect to the outer side.

6. Actuator installation method according to one of the preceding claims, **characterized**
**in that** step a) comprises:
providing the shell structure (72) with at least one flat surface (82) on the inner side (76) of the shell structure (72), and in that step c) comprises:
fastening the at least one first actuator (54) and the at least one second actuator (55) to the at least one flat surface (82).

7. Actuator installation method according to one of the preceding claims, **characterized**
**in that** step b) comprises:
b.1) providing at least one piezoelectric actuator (54, 55) .

8. Manufacturing method for manufacturing a mechanical ice protection device (37) for an aircraft for keeping a surface region (14) of the aircraft (16) free from ice and/or for deicing same by means of carrying out an actuator installation method according to one of the preceding claims, wherein the shell structure (72) has the surface region (14), which is to be kept free from ice and/or is to be deiced, on its outer side.

9. Manufacturing method for manufacturing a hybrid ice protection device (10) for an aircraft, for thermally and mechanically keeping a surface region (14) free from ice and/or for deicing same, comprising:
carrying out a manufacturing method for manufacturing a mechanical ice protection device (37) for an aircraft for keeping a surface region (14) of the aircraft (16) free from ice and/or for deicing same, according to Claim 8, and by means of the step of:
d) attaching a heat output device (12) for heating at least part of the shell structure (72).

10. Manufacturing method according to Claim 9, **characterized**
**in that** step d) comprises:
d1) providing a heat output device (12) which is designed for linear heat output for the purpose of producing a predetermined breaking point or predetermined breaking line (32) or separating line in ice accumulating on the surface region (14), and
d2) attaching the heat output device (12) to the inner side (76) of the shell structure in the region of a front edge (26) and/or a stagnation line (34) of a profile body (18) to be formed by the shell structure (72).

## Revendications

1. Procédé de montage d'actionneur servant au montage d'au moins un actionneur (54, 55) dans une structure de coque d'un profilé (36) d'un corps profilé (18) d'un aéronef, laquelle structure de coque est fortement incurvée ou renferme un espace restreint, comprenant les étapes suivantes :
a) la fourniture de la structure de coque (72),
b) la fourniture d'au moins un actionneur (54, 55) qui est approprié à la déformation d'une région de surface (14) de la structure de coque (72), par fourniture d'au moins un premier actionneur (54) servant à la déformation d'une partie (38) de la région de surface (14) formée sur une première moitié longitudinale (78) de la structure de coque (72) et fourniture d'au moins un deuxième actionneur (55) servant à la déformation d'une partie (39) de la région de surface (14) formée sur une deuxième moitié longitudinale (80) de la structure de coque (72), et
c) la fixation de l'au moins un actionneur (54, 55) à un côté intérieur (76) de la structure de coque (72) par fixation simultanée de l'au moins un premier actionneur (54) au côté intérieur de la première moitié longitudinale (78) et de l'au moins un deuxième actionneur (80) au côté intérieur de la deuxième moitié longitudinale (80),
**caractérisé en ce que** l'étape c) contient :
c1) l'agencement de l'au moins un actionneur (54, 55) sur un poinçon (86) servant à presser à plat l'au moins un actionneur (54, 55) contre le côté intérieur de la structure de coque (72),
c2) l'adhésion de l'actionneur (54, 55) au poinçon (86) par le biais d'un moyen de retenue (90) libérable,
c3) le pressage de l'actionneur (54, 55) contre le côté intérieur de la structure de coque (72) à l'intérieur du profilé (36) au moyen du poinçon (86),
c4) la liaison de l'actionneur (54, 55) au côté intérieur (76),
c5) la libération et/ou le retrait du poinçon (86).

2. Procédé de montage d'actionneur selon la revendication 1,
**caractérisé en ce que**
l'étape c4) contient au moins l'une des étapes suivantes
c4.1) la liaison de matière des actionneurs (54, 55) au côté intérieur (76) ;
c4.2) le collage, sur une grande surface ou sur toute la surface, des actionneurs (54, 55) sur le côté intérieur (76) ;
c4.2.1) l'application d'un adhésif (102) sur le côté intérieur (76) et/ou une surface des actionneurs (54, 55) qui doit être collée sur le côté intérieur (76) avant la fixation des actionneurs (54, 55) au côté intérieur (76),
c4.2.2) le durcissement de l'adhésif (102) par pressage des actionneurs (54, 55) selon l'étape c3) ; et/ou
c4.3) l'interposition d'une couche d'isolation électrique (106) entre l'actionneur (54, 55) et le côté intérieur (76).

3. Procédé de montage d'actionneur selon l'une des revendications précédentes, **caractérisé en ce que** l'étape c2) contient :
c2.1) la retenue des actionneurs (54, 55) sur le poinçon au moyen d'un ruban adhésif double face (110) pendant l'insertion dans la structure de coque (72) et/ou la fixation à la structure de coque (72).

4. Procédé de montage d'actionneur selon l'une des revendications précédentes, **caractérisé en ce que** l'étape c3) contient l'étape suivante :
c3.1) le mouvement guidé du poinçon (86) par le biais d'un dispositif de guidage (94).

5. Procédé de montage d'actionneur selon l'une des revendications précédentes, **caractérisé en ce que** l'étape c3) contient au moins l'une des étapes suivantes
c3.2) le maintien et/ou le maintien à un niveau constant d'une pression de pressage au moyen d'un
accumulateur de force, par exemple une rondelle Belleville, et/ou
c3.3) le support du côté extérieur de la structure de coque (72) au moyen d'une forme de support (92) complémentaire au côté extérieur.

6. Procédé de montage d'actionneur selon l'une des revendications précédentes, **caractérisé en ce que** l'étape a) contient :
la fourniture de la structure de coque (72) comportant au moins une surface plane (82) sur le côté intérieur (76) de la structure de coque (72) et **en ce que** l'étape c) contient :
la fixation de l'au moins un premier actionneur (54) et de l'au moins un deuxième actionneur (55) à l'au moins une surface plane (82).

7. Procédé de montage d'actionneur selon l'une des revendications précédentes, **caractérisé en ce que** l'étape b) contient :
b.1) la fourniture d'au moins un actionneur piézoélectrique (54, 55).

8. Procédé de fabrication servant à la fabrication d'un dispositif anti-givrage mécanique (37) pour un aéronef servant à maintenir une région de surface (14) de l'aéronef (16) dépourvue de givre et/ou à la dégivrer par mise en œuvre d'un procédé de montage d'actionneur selon l'une des revendications précédentes, la structure de coque (72) présentant la région de surface (14) devant être maintenue dépourvue de givre et/ou à dégivrer sur son côté extérieur.

9. Procédé de fabrication servant à la fabrication d'un dispositif anti-givrage hybride (10) pour un aéronef, servant à maintenir une région de surface (14) dépourvue de givre et/ou à la dégivrer de manière thermique et mécanique, comprenant :
la mise en œuvre d'un procédé de fabrication servant à la fabrication d'un dispositif anti-givrage mécanique (37) pour un aéronef servant à maintenir une région de surface (14) de l'aéronef (16) dépourvue de givre et/ou à la dégivrer selon la revendication 8 et par l'étape suivante :
d) fixation d'un dispositif d'émission de chaleur (12) servant à réchauffer au moins une partie de la structure de coque (72).

10. Procédé de fabrication selon la revendication 9, **caractérisé en ce que**
l'étape d) contient :
d1) la fourniture d'un dispositif d'émission de chaleur (12) qui est réalisé pour l'émission de chaleur linéaire en vue de générer un point de rupture imposée ou une ligne de rupture imposée (32) ou une ligne de séparation dans du givre s'accumulant sur la région de surface (14), et
d2) la fixation du dispositif d'émission de chaleur (12) au côté intérieur (76) de la structure de coque dans la région d'un bord d'attaque (26) et/ou d'une ligne de stagnation (34) d'un corps profilé (18) devant être formé par la structure de coque (72).
